(19) Europäisches Patentamt

European Patent Office

Office européen des brevets

(11) **EP 1 733 999 A1**

(12) **EUROPEAN PATENT APPLICATION**

(43) Date of publication:
**20.12.2006 Bulletin 2006/51**

(51) Int Cl.:
*B81B 3/00* (2006.01)     *H01H 1/00* (2006.01)

(21) Application number: **05105336.1**

(22) Date of filing: **16.06.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **15.06.2005 US 691224**

(71) Applicant: **INTERUNIVERSITAIR MICROELEKTRONICA CENTRUM VZW
3001 Leuven (BE)**

(72) Inventors:
• **Tilmans, Hendrikus
3630 Maasmechelen (BE)**
• **Klaasse, Gerald
7364 BT, Lieren (NL)**

(74) Representative: **Sarlet, Steven Renaat Irène et al
Gevers & Vander Haeghen,
Holidaystraat, 5
1831 Diegem (BE)**

(54) **Microelectromechanical device with stress and stress gradient compensation**

(57)     A micro electromechanical device comprising a floating element extending between at least two anchors, the floating element comprising a predetermined reference portion, which in at least one predetermined state of the device in use is to be located within a predetermined reference plane, and at least two flexible sections which each extend between the reference portion and one of the anchors, at least two of the flexible sections comprising a stress relieving element which enables deflection of the floating element as a result of a stress gradient, characterised in that the stress relieving elements are provided on predetermined locations between the respective anchor and the reference portion, chosen such that the reference portion is substantially located within the predetermined reference plane in said predetermined state of the device in use.

*FIG. 3*

## Description

The present invention relates to a micro electromechanical (MEM) device according to the preamble of the first claim.

A MEM device generally comprises a floating element, such as for example an actuator beam or a membrane, which can be used for a variety of functions, e.g. as electrode of a variable capacitor, as a switching means, or other. The actuation can be for example electrostatic, piezoelectric, thermoelectric or electromagnetic. The floating element extends between two or more anchors and comprises a predetermined reference portion, which is used for reference purposes according to the function of the MEM device, and flexible sections which suspend the reference portion on the anchors. The floating element can be fabricated with thin film deposition techniques and can therefore have residual stresses and stress gradients. Deposition conditions can be determined for optimizing these stresses, but process uncertainties are remaining, leading to unpredictable stresses in the floating element. In addition, the temperature after fabrication can vary, which results in thermal stresses. All these stresses lead to varying properties of the MEM device.

In order to make MEM devices that are less sensitive for stresses, corrugations have been introduced on the floating elements, which function as springs and release the average stress. However, these corrugations introduce an initial deflection of the floating element due to stress gradients. This initial deflection strongly influences the characteristics of the device, for example the actuation voltage in case of electrostatic actuation. This is undesired, especially when the actuation voltage is limited, e.g. for RF-MEMS components in battery powered wireless communication systems.

It is therefore an aim of this invention to provide a micro electromechanical device which has stress relieving elements for releasing stress and with which the effects of stress gradient can be compensated.

This aim is achieved with a micro electromechanical device showing the technical characteristics of claim 1.

The micro electromechanical device of the invention comprises a floating element which extends between at least two anchors. It has a predetermined reference portion, which in at least one predetermined state of the device in use is to be located within a predetermined reference plane. This plane is chosen in view of the desired characteristics of the device in use in at least one state. The floating element comprises at least two flexible sections which each extend between the reference portion and one of the anchors. At least two of these flexible sections comprise a stress relieving element, which releases the stress and causes the deflection of the floating element as a result of a stress gradient. The location of these stress relieving elements on their respective flexible sections is chosen such between the reference portion and the respective anchor, that the deflection of the floating element at the reference portion is such that this portion is located in the predetermined reference plane in the predetermined state of the device in use.

The predetermined state of the device, in which the reference portion is to be located in the reference plane, can for example be an initial state, i.e. a state in which no actuation forces are applied to the floating element. It may however also be another state of the device, e.g. a state in which a given actuation force is applied. The predetermined reference plane, being a plane in which the reference portion is to be located in a predetermined state of the device in use, is substantially parallel to the plane in which the reference portion, or the whole floating element, generally extends.

An analysis of the problem of the prior art has shown that the corrugations, which function as stress relieving elements, are usually placed near the anchor points in view of avoiding an impact on the strength of the floating element. However, this makes the design highly sensitive to stress gradients.

According to the invention, the location of the stress relieving elements is determined for controlling the effect of the stress gradient, i.e. the deflection of the floating element. Their location can for example be chosen such that the deflection can be minimized at the reference portion. By adequately placing the stress relieving elements, the effects of both average stress and stress gradient can be cancelled out for at least the predetermined state and floating elements, such as for example MEM actuator beams or membranes, can be designed with properties substantially independent to process variations and to thermally induced stresses after fabrication.

In one embodiment of the MEM device of the invention, the floating element is actuatable between an upstate and a downstate, the reference portion being substantially within the reference plane in the upstate. So in this embodiment, the location of the stress relieving elements on their respective flexible portions is chosen such that the deflection of the floating element at the reference portion is minimised in the upstate.

In this embodiment, the floating element is preferably actuated by means of an actuator which is located in an actuation plane at a predetermined height below the reference plane. The position of the actuator in the actuation plane can be underneath the reference portion, when the lowest actuation force is desired, or offset, as has for example been described in the European patent application no. 05103893.3, which is hereby incorporated by reference.

This embodiment is for example suitable for switching an RF signal line. The actuator can then conveniently be part of the RF signal line, or it can be a separate actuator.

A dielectric layer with a predetermined thickness may be provided on top of the actuator in view of a capacitance of the device in the downstate. Further, a conductive layer may be deposited on top of the dielectric layer to improve contact, as has for example been described in the European patent application no. 03020159.4 published as EP-A-1398811 and in the European patent application no. 05103893.3, which are hereby incorporated by reference.

The stress relieving elements of the MEM device of the invention may be formed by corrugations or any other equivalent means known to the person skilled in the art. The corrugations may be substantially any structure which comprises a spring like functionality. Such a structure can be essentially planar or extend in 3 dimensions..

In an advantageous embodiment of the MEM device of the invention, the flexible sections have a constant cross-section and each stress relieving element is located substantially in the middle of the respective section. This embodiment has the advantage of being simple in design. The constant cross-section means that the height and the width of the section is substantially the same over its entire length. In certain embodiments the cross section surface can be constant, rather than the cross-section itself. In other embodiments the width and/or height of the flexible sections may vary along its longitudinal direction. A varying width is typically more easily producable for a layered structure than a varying height. In certain embodiments the flexible section are multi layer structures; for multi layer structures a varying height is easily producable, although substantially discrete height variations are typical for thin film processing.

In another advantageous embodiment of the MEM device of the invention, the floating element comprises two flexible sections on opposite sides of the reference portion. This embodiment has the advantage of being simple in design, especially in combination with the features of the foregoing paragraph. However, embodiments with more flexible sections, non-constant cross sections and/or non-centred stress relieving elements are also possible. It is furthermore not considered essential that each flexible section, in case there are more than two, comprises a stress relieving element.

The reference portion can be a rigid portion or a flexible portion of the floating element. It can have a predetermined length, for example for making a suitable contact with a given electrode of the device, but it can also be a point.

The invention further relates to a method for designing a MEM device as described above which comprises the step of determining the location of the stress relieving elements in such a way that the reference portion is substantially located within the reference plane in the predetermined state. In case a substantially zero deflection of the reference portion is desired, the method can conveniently comprise the simple step of modelling each section as a bridge between two fixed points, one being the anchor and the other being the connection between the section and the reference portion. In this way, the location of the stress relieving elements can be easily determined.

The invention will be further elucidated by means of the following description and the appended figures.

Figure 1 shows a cross-sectional view and the influence of average stress and stress gradient for a clamped-clamped beam configuration (a) and clamped-free beam configuration (b).

Figure 2 shows a schematic top view of a corrugation, placed in a clamped-clamped beam (a) and the corresponding mechanical model in cross-sectional view (b).

Figure 3 shows a schematic top view of a designed RF-MEMS switch with zero initial deflection according to the invention.

Figure 4 shows optical photographs of fabricated electrostatically actuated beams without corrugations (a), with non-optimized placement of corrugations (b) and with optimized placement of corrugations (c).

Figure 5 shows profiles of the three fabricated beams of Fig. 4, measured with white light interferometry.

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. Where the term "comprising" is used in the present description and claims, it does not exclude other elements or steps.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

A key element in many MEM components is the actuator, which transforms an electrical signal into a mechanical movement. A MEM generally comprises a beam or membrane or like element, i.e. a floating element overhanging the actuator and which is actuated with for example electrostatic, piezoelectric, thermoelectric or electromagnetic actuation. In the embodiments shown in the figures and described below, the floating element which is described is a beam 10, also called actuator beam, but it is understood that other floating elements can also be applied according to the invention.

The beams 10 are fabricated with thin film deposition techniques and have therefore residual stresses and stress gradients. These stresses can be optimized by optimizing the deposition conditions, but process uncertainties are remaining, leading to unpredictable stresses in the beam. This is particularly the case for multilayer beams. Multilayer beams can be for instance electrothermal and piezoelectric beams. In addition, the temperature after fabrication can vary, which results in thermal stresses. All these stresses lead to varying properties of the actuator beam 10.

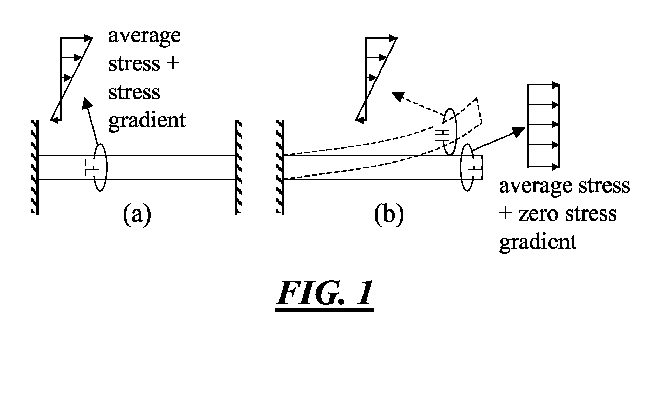

Two basic beam configurations that are commonly used are the clamped-clamped beam and the clamped-free beam configuration, as shown in Figure 1. The clamped-free configuration shows initial deflection when a stress gradient is present, but an average stress has no influence on the stiffness of the beam. The stiffness of a clamped-clamped beam on the other hand is strongly influenced by an average stress, but has no initial deflection due to a stress gradient. The effects of beam stiffening and initial deflection strongly influence the characteristics of actuator beams, especially the actuation voltage. This is undesired, especially when the actuation voltage is limited, e.g. for RF-MEMS components in battery powered wireless communication systems.

In order to make the actuator beam 10 less sensitive for stresses, a compromise is made between the two different beam configurations by using a clamped-clamped beam 10 with stress relieving elements 5, for example corrugations. These stress relieving elements 5 function as springs and release the average stress, but cause an initial deflection of the beam 10 as a result of stress gradients. In order to compensate for this initial deflection at the reference point or area 3, i.e. the portion of the beam 10 which is actuated, the location of the stress relieving elements 5 is determined in advance in such a way that the reference portion 3 of the beam 10 in at least one predetermined state is within a predetermined reference plane. For example if the initial deflection of the reference portion 3 is to be minimized, the predetermined state is the initial state of the device when no actuation forces are acting on the reference portion 3 and the predetermined reference plane is the plane in which the beam 10 mainly extends or the plane in which its anchors 1, 2 are located.

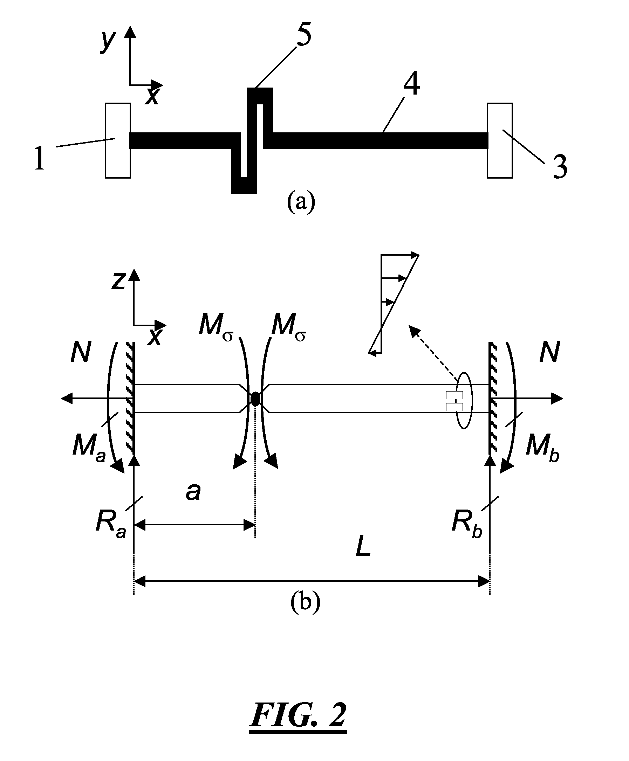

In order to determine the location of the stress relieving elements 5, for example corrugations, the following mechanical model is used: the beam 5 is modeled as a number of flexible sections 4 commonly connected to the reference point 3, which is treated as a fixed point in the same way as an anchor point 1, 2. When a corrugation 5 is placed in a clamped-clamped beam 10, the stiffness of the beam is locally disturbed. A possible design of a corrugation 5 in a clamped-clamped beam is shown in Figure 2a. This corrugation 5 can be modeled as a hinge (see Figure 2b), which releases the stress and allows locally a discontinuous torsion of the beam 10. The stiffness of the beam is reduced because of this possibility for torsion, but it is less depending on the stress than before.

In the following analysis, it is assumed that each section 4 has a continuous cross-section, i.e. a constant width and height. For sections 4 or beams 10 not having such a continuous cross-section, some additional parameters will have to be taken into account. Further, it is assumed that average stresses are fully released in the corrugation 5, making the normal forces N equal to zero.

The bending moments $M_\sigma$ originate from a non-uniform stress distribution over the thickness of the beam 10 and act to the left and to the right of this hinge. They have the same magnitude, but act in opposite rotation directions. The reaction moments $M_a$ and $M_b$ are equal to $M_\sigma$, as it is the case for a clamped-clamped beam without hinge. If there is no hinge, the moments cancel out over the entire length of the beam and do not cause any deflection and reaction forces.

The applied bending moments $M_\sigma$ cause reaction forces $R_A$ and $R_B$ at the clamped edges 1, 3, which are given by:

$$R_A = -R_B = \frac{3M_\sigma}{2}\left[\frac{2a - L}{a(L - a)}\right]$$

In order to obtain an equivalent behavior at the anchor points 1, 3 as for the beam without hinge, the reaction forces $R_A$ and $R_B$ should be equal to zero. This is only the case when the hinge is placed in the middle of the beam, i.e. when a = L/2. This means that such a beam has reaction forces equal to zero and reaction moments equal to $M_\sigma$, when the hinge is placed at x = L/2. This feature can be used to design an actuator beam 10 that is insensitive for both stress and stress gradient, as it will be demonstrated below.

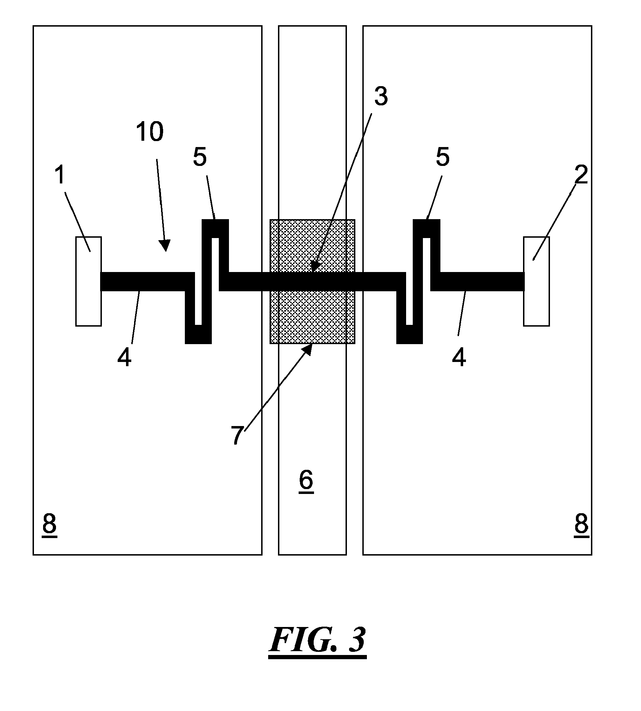

Based on the above-mentioned analysis, actuator beams 10 can be designed which are insensitive for both stress and stress gradient. As an example, the design of an electrostatically actuated RF-MEMS switch is given here. An electrostatically actuated RF-MEMS switch comprises a beam 10 suspended over an RF-signal line 6, as shown in Figure 3. A dielectric 7 is provided on top of the RF signal line 6 in the actuation area. The beam 10 extends between two anchors 1, 2, provided on an RF-ground layer 8. Further possible features of such an RF-MEMS switch are described in the European patent application no. 03020159.4 published as EP-A-1398811 and in the European patent application no. 05103893.3, which are hereby incorporated by reference.

Using the mathematical method described above, the RF-MEMS switch of figure 3 is designed such that there is substantially no initial deflection at the reference area. Here, this reference area is reduced to the reference point 3, since there is only one point 3 where the initial deflection needs to be zero. As a result, the beam is designed with two basic segments 4 which extend from the reference point 3 up to the anchors 1, 2. The reference point 3 is here the centre of the beam 10 and also the centre of the actuation area, which is the overlap of the beam 10 with the RF-signal line 6. If a beam consists of a series of basic segments as shown in Figure 2 with a = L/2, this beam 10 will have zero deflection at all the points where the basic segments 4 are connected. Since the beam 10 has a constant cross-section, the mathematical method results in the corrugations 5 being placed in the middle of their respective sections 4. This design differs from reported structures, where corrugations 5 are commonly placed near the anchor points 1, 2.

The same mathematical method can be used for designing beams or structures which have a reference portion or area rather than a reference point. This reference portion or area can be flexible or rigid. The method can also be used for off-centre reference portions or points and structures having more than two flexible sections 4, some of which may even not have a corrugation 5.

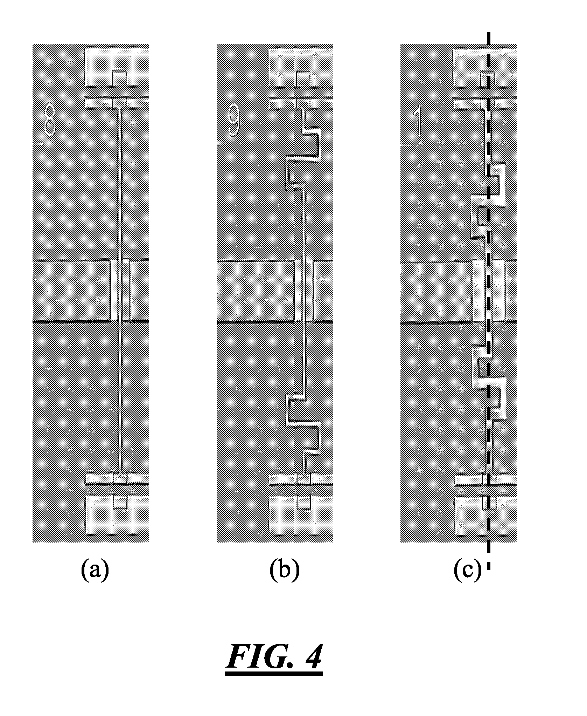

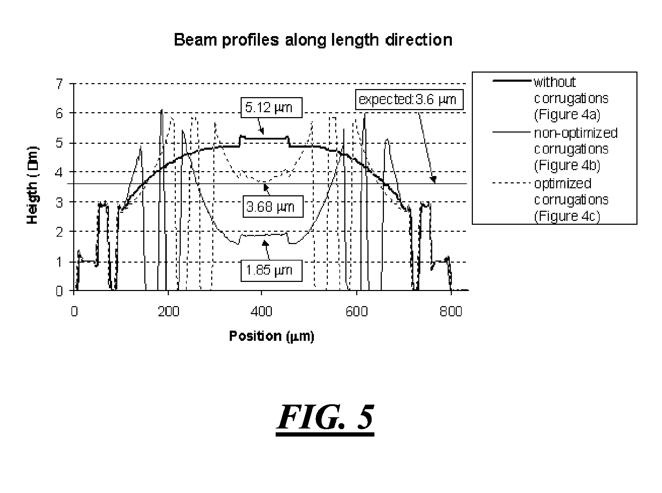

Figure 4 shows photographs of electrostatically actuated beams which have been fabricated. An aluminum layer of 400 nm thick was used as the bottom electrode. On top of the bottom electrode, 200 nm of AIN was deposited as a dielectric layer to provide electric isolation between the bridge and the bottom electrode. A 1 $\mu$m thick aluminum beam with average tensile stress of 200 MPa (calculated from wafer bow measurement of a full wafer) and stress gradient of 70 MPa / $\mu$m (calculated from cantilever deflection measurement) was deposited on top of a 2 $\mu$m thick polyimide sacrificial layer. With this process, beams without corrugations (Figure 4a), with non-optimized placement of corrugations (Figure 4b) and optimized placement of corrugations (Figure 4c) were designed and fabricated.

The profiles of these beams after fabrication were measured with white light interferometry along the length of the beams, as indicated by the dotted line in Figure 4c. The results are illustrated by Figure 5, which shows the measured values for the height of the beam above the bottom electrode. The height is the sum of the thicknesses of the deposited layers. If no planarization effects occur during the processing of the sacrificial layer, this value is 3.6 $\mu$m.

The initial deflection of the beam without corrugations shows a positive initial deflection. This was unexpected from the measured average stress value, but the stress in the beam on top of the sacrificial layer is likely to be different from the stress as measured by wafer-bow measurement on a full wafer.

The beam with non-optimized corrugations shows a big initial deflection downwards, as expected from the theory.

The beam with the optimized placement of corrugations has an initial deflection that is very close to the expected value, meaning that there is almost zero initial deflection. This shows that the placement of corrugations in a clamped-clamped beam can be done such that the stress is efficiently released and the stress gradient does not influence the initial deflection at the actuation area of the beam.

## Claims

1. A micro electromechanical device comprising a floating element extending between at least two anchors, the floating element comprising a predetermined reference portion, which in at least one predetermined state of the device in use is to be located within a predetermined reference plane, and at least two flexible sections which each extend between the reference portion and one of the anchors, at least two of the flexible sections comprising a stress relieving element which enables deflection of the floating element as a result of a stress gradient, **characterised in that** the stress relieving elements are provided on predetermined locations between the respective anchor and the reference portion, chosen such that the reference portion is substantially located within the predetermined reference plane in said predetermined state of the device in use.

2. A micro electromechanical device according to claim 1, **characterised in that** the floating element is actuatable between an upstate and a downstate, the reference portion being substantially within the reference plane in the upstate.

3. A micro electromechanical device according to claim 2, **characterised in that** the device comprises an actuator for actuating the floating element, the actuator being located in an actuation plane at a predetermined height below the reference plane.

4. A micro electromechanical device according to claim 3, **characterised in that** the actuator is part of an RF signal line.

5. A micro electromechanical device according to claim 3 or 4, **characterised in that** a dielectric layer is provided on top of the actuator, said dielectric having a predetermined thickness in view of a capacitance of the device in the downstate.

6. A micro electromechanical device according to claim 5, **characterised in that** a conductive layer is deposited on top of the dielectric layer.

7. A micro electromechanical device according to any one of the claims 1-6, **characterised in that** each stress relieving element comprises a corrugation.

8. A micro electromechanical device according to any one of the claims 1-7, **characterised in that** each flexible section has a constant cross-section and that each stress relieving element is located substantially in the middle of the respective section.

9. A micro electromechanical device according to any one of the claims 1-8, **characterised in that** the floating element comprises two flexible sections on opposite sides of the reference portion.

**10.** A micro electromechanical device according to any one of the claims 1-9, **characterised in that** the reference portion is a point.

**11.** A method for designing a micro electromechanical device comprising a floating element extending between at least two anchors, the floating element comprising a predetermined reference portion, which in at least one predetermined state of the device in use is to be located within a predetermined reference plane, and at least two flexible sections which each extend between the reference portion and one of the anchors, at least two of the flexible section comprising a stress relieving element which enables deflection of the floating element as a result of a stress gradient, **characterised in that** the method comprises the step of determining locations for the stress relieving elements between the respective anchor and the reference portion in such a way that the reference portion is substantially located within the reference plane in said predetermined state.

**12.** The method according to claim 11, further comprising the step of modelling each section as a bridge between two fixed points, one being the anchor and the other being the connection with the reference portion.

**FIG. 1**

**FIG. 2**

**FIG. 3**

(a)     (b)     (c)

# *FIG. 4*

FIG. 5

**European Patent Office**

**EUROPEAN SEARCH REPORT**

Application Number

EP 05 10 5336

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 343 190 A (MURATA MANUFACTURING CO., LTD) 10 September 2003 (2003-09-10) * paragraph [0074] - paragraph [0093] * * paragraph [0109] - paragraph [0120] * | 1-4,7-12 | B81B3/00 H01H1/00 |
| Y | * figures 5,10 * | 5,6 | |
| X | US 2002/160549 A1 (SUBRAMANIAN ARUNKUMAR ET AL) 31 October 2002 (2002-10-31) | 1-4,7-12 | |
| Y | * paragraph [0025] - paragraph [0032]; figures 3,6 * | 5,6 | |
| X | US 2003/082917 A1 (HOPKINS DEAN A ET AL) 1 May 2003 (2003-05-01) * paragraph [0021] - paragraph [0026] * | 1-3,7-12 | |
| Y | * figure 5 * | 5,6 | |
| D,Y | EP 1 398 811 A (INTERUNIVERSITAIR MICROELEKTRONICA CENTRUM VZW) 17 March 2004 (2004-03-17) * figure 13 * * paragraph [0058] - paragraph [0061] * * abstract * | 5,6 | TECHNICAL FIELDS SEARCHED (Int.Cl.7) B81B H01H |

The present search report has been drawn up for all claims

| Place of search | Date of completion of the search | Examiner |
|---|---|---|
| Berlin | 13 September 2005 | Meister, M |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**                EP 05 10 5336

This annex lists the patent family members relating to the patent documents cited in the above-mentioned European search report.
The members are as contained in the European Patent Office EDP file on
The European Patent Office is in no way liable for these particulars which are merely given for the purpose of information.

13-09-2005

| Patent document cited in search report | | Publication date | Patent family member(s) | | Publication date |
|---|---|---|---|---|---|
| EP 1343190 | A | 10-09-2003 | US | 2003223176 A1 | 04-12-2003 |
| US 2002160549 | A1 | 31-10-2002 | NONE | | |
| US 2003082917 | A1 | 01-05-2003 | WO | 03035542 A2 | 01-05-2003 |
| EP 1398811 | A | 17-03-2004 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 05103893 A
- EP 03020159 A
- EP 1398811 A